# EUROPÄISCHE PATENTSCHRIFT

(11) **EP 2 636 081 B1**
(45) Veröffentlichungstag und Bekanntmachung des Hinweises auf die Patenterteilung: **09.08.2017**
(21) Anmeldenummer: 11775797.1
(22) Anmeldetag: 26.10.2011
(51) Int. Cl.: H01L 41/053, H01L 41/23

(54) **AKTOREINHEIT UND VERFAHREN ZUR FERTIGUNG DERSELBEN**
ACTUATOR UNIT AND METHOD FOR PRODUCING THEREOF
UNITÉ ACTIONNEUR ET SON PROCÉDÉ DE PRODUCTION

(30) Priorität: 02.11.2010 DE 102010050266
(43) Veröffentlichungstag der Anmeldung: 11.09.2013
(73) Patentinhaber: Epcos AG, 81669 München (DE)
(72) Erfinder: KREITER, Johann, 8530 Deutschlandsberg (AT); FELLNER, Siegfried, A-8413 St. Georgen (AT)
(74) Vertreter: Epping - Hermann - Fischer
(86) Internationale Anmeldenummer: PCT/EP2011/068759
(87) Internationale Veröffentlichungsnummer: WO 2012/059380

(56) Entgegenhaltungen:
- DE-A1- 10 133 151
- DE-A1- 19 715 487
- DE-A1-102007 026 137
- DE-A1-102008 003 821

## Beschreibung

Die Erfindung betrifft eine Aktoreinheit, ein Verfahren zur Fertigung einer Aktoreinheit sowie eine Hülse zur Aufnahme eines Piezoaktors.

Piezoaktoren umfassen im Allgemeinen mehrere Schichten eines piezoelektrischen Materials. Piezoaktoren können zum Beispiel zum Betätigen eines Einspritzventils in einem Kraftfahrzeug eingesetzt werden. Eine Hülse ist zum Schutz eines Piezoaktors vor Umwelteinflüssen von Bedeutung, wenn die Lebensdauer des Piezoaktors möglichst lang gehalten werden soll.

Piezoaktoren sind beispielsweise aus der DE 10 2004 031 404 A1 und der DE 10 2006 025 177 A1 bekannt. Des Weiteren ist aus der Druckschrift DE 19715487 A1 ein piezoelektrischer Aktor mit einem Hohlprofil bekannt, wobei piezoelektrische Schichten, Kontaktstifte und Kontaktfahnen des Aktors im Inneren des Hohlprofils angeordnet und von einer Passivierungsschicht umgossen sind. Die Druckschrift
DE 102008003821 A1 betrifft eine piezoelektrische Aktoreinheit mit einem Piezoaktor, der in einer Hülse angeordnet und von einer Vergussmasse umhüllt ist. Die Druckschrift DE 102007026137 A1 betrifft ein Verfahren zum Herstellen einer Aktoreinheit, bei der ein Piezoaktor in einer Schutzhülle angeordnet wird und das Innere des Hohlraums der Schutzhülle mit einer Vergussmasse aufgefüllt wird. Die Druckschrift DE 10133151 A1 betrifft ein Piezoaktor-Bauelement, das in einer Hülse angeordnet ist, wobei ein Ende der Hülse von einem Deckel verschlossen ist, während das andere Ende der Hülse von einem Endbereich eines Sockels verschlossen ist.

Aufgabe der Erfindung ist es, eine Aktoreinheit sowie ein Verfahren zur Fertigung einer Aktoreinheit anzugeben, wodurch die Zuverlässigkeit und die Lebensdauer eines Piezoaktors erhöht wird.

Die Aufgabe wird durch eine Aktoreinheit gemäß dem Patentanspruch 1 sowie durch ein Verfahren zur Fertigung einer Aktoreinheit gemäß dem Patentanspruch 8 gelöst.

Es wird eine Aktoreinheit angegeben, die einen Piezoaktor umfasst. Der Piezoaktor weist eine erste Stirnfläche und eine zweite Stirnfläche auf. Die Aktoreinheit umfasst weiterhin eine Hülse zur Aufnahme des Piezoaktors. Die Hülse weist eine erste Stirnfläche und eine zweite Stirnfläche auf. Die Aktoreinheit umfasst weiterhin eine den Piezoaktor umgebende Vergussmasse. Der Piezoaktor und die Vergussmasse sind in die Hülse eingebracht. Die Vergussmasse reicht bis an die erste Stirnfläche des Piezoaktors.

Die Hülse ist dazu ausgelegt den Piezoaktor vor Umwelteinflüssen, wie beispielsweise hohen Temperaturen, die etwa im Motorraum eines Kraftfahrzeugs auftreten, zu schützen. Die Hülse erhöht somit die Lebensdauer des Piezoaktors. Die Hülse dient weiterhin der Formstabilisierung der Vergussmasse.

Die Vergussmasse umgibt den Piezoaktor. Vorzugsweise reicht die Vergussmasse genau bis zur ersten Stirnfläche des Piezoaktors. Die erste Stirnfläche des Piezoaktors ist näher an der ersten Stirnfläche der Hülse angeordnet als die zweite Stirnfläche des Piezoaktors. Erfindungsgemäß schließt die Vergussmasse mit der ersten Stirnfläche des Piezoaktors bündig ab. Ein Überstehen der Vergussmasse über die erste Stirnfläche des Piezoaktors, wodurch beispielsweise Anschlusselemente des Piezoaktors verschmutzt und somit eine externe Kontaktierung des Piezoaktors erschwert werden könnte, wird vermieden.

In einer vorteilhaften Ausführung weisen die erste Stirnfläche des Piezoaktors und die erste Stirnfläche der Hülse die gleiche axiale Position in Bezug auf die Hauptachse der Aktoreinheit aufweisen.

Vorteilhafterweise entspricht die Höhe bzw. Länge der Hülse in etwa der Höhe des Piezoaktors. Dadurch kann erreicht werden, dass die Vergussmasse mit der ersten Stirnfläche des Piezoaktors und gleichzeitig mit der ersten Stirnfläche der Hülse bündig abschließt. Dadurch wird die Stabilität und Lebensdauer der Aktoreinheit erhöht. Weiterhin kann eine automatische Fertigung der Aktoreinheit erleichtert werden, da die Vergussmasse immer auf ein bestimmtes Niveau, beispielsweise bis zu ersten Stirnfläche der Hülse und des Piezoaktors, aufgefüllt wird. Fertigungskosten können auf diese Weise reduziert werden.

In einer Ausführungsform der Aktoreinheit ist die Hülse einstückig ausgebildet.

Durch eine einstückige Hülse kann eine automatische Herstellung der Aktoreinheit weiter erleichtert werden. Es kann ein Austreten der Vergussmasse an Verbindungsstellen verschiedener Hülsenteile vermieden werden. Somit kann eine einfach herstellbare und kostengünstige Aktoreinheit erzielt werden. Des Weiteren kann durch die einstückige Ausführung der Hülse ein Verkanten des Piezoaktors an Verbindungsstellen von mehreren Hülsenteilen beim Einbringen des Piezoaktors vermieden werden.

In einer Ausführungsform der Aktoreinheit weist die zweite Stirnfläche der Hülse einen Durchbruch auf. Die zweite Stirnfläche des Piezoaktors ist in den Durchbruch eingeführt.

Vorzugsweise hat der Durchbruch die Form eines Vierkants. Der Durchbruch weist eine Abmessung auf, welche in etwa der Abmessung der zweiten Stirnfläche des Piezoaktors entspricht. Vorzugsweise ist die Abmessung der zweiten Stirnfläche des Piezoaktors kleiner oder maximal gleich der Abmessung des Durchbruchs, so dass die zweite Stirnfläche des Piezoaktors leicht in den Durchbruch eingeführt werden kann.

In einer Ausführungsform der Aktoreinheit ist die zweite Stirnfläche des Piezoaktors derart in den Durchbruch eingeführt, dass die zweite Stirnfläche des Piezoaktors aus der zweiten Stirnfläche der Hülse herausragt.

In einer Ausführungsform der Aktoreinheit weist die erste Stirnfläche der Hülse eine Öffnung auf. Die Öffnung ist zum Einbringen des Piezoaktors in die Hülse geeignet.

Vorzugsweise hat die Hülse die Form eines Zylinders. Die erste Stirnfläche der Hülse ist offen, so dass der Piezoaktor durch die Öffnung in die Hülse eingebracht werden kann. Die zweite Stirnfläche der Hülse bildet den Boden der Hülse, wobei der Boden den oben beschrieben Durchbruch zur Aufnahme der zweiten Stirnfläche des Piezoaktors aufweist.

In einer Ausführungsform der Aktoreinheit weist das Material der Hülse PBT auf.

Vorzugsweise enthält die Hülse ein Material umfassend ein thermoplatisches Polyester, beispielsweise Polybutylenterephthalat (PBT). Dieses Material weist hydrophobe Eigenschaften auf. Gleichzeit verleiht dieses Material der Hülse eine zur Formstabilisierung der Vergussmasse ausreichende mechanische Festigkeit bzw. Stabilität. Weiterhin ist besagtes Material gegenüber Temperaturen beständig. Darüber hinaus hat PBT den Vorteil, dass das Material auf Grund seiner chemischen Stabilität nicht zum Piezoaktor absondert und diesen chemisch verunreinigt. Vorzugsweise geht das Material der Hülse eine Verbindung mit der Vergussmasse ein, wodurch Hohlräume zwischen der Vergussmasse und der Hülse weitgehend vermieden werden.

In einer Ausführungsform der Aktoreinheit umfasst der Piezoaktor einen Stapel von piezokeramischen Schichten sowie zwischen den piezokeramischen Schichten angeordneten Elektrodenschichten umfasst. Die Elektrodenschichten sind gegenpolig kontaktiert.

Beispielsweise weisen die piezokeramischen Schichten eine Blei-Zirkonat-Titanat (PZT) Keramik auf. Die Elektrodenschichten enthalten vorzugsweise eines der folgenden Materialien: Silber, Palladium, Platin, Kupfer, Nickel. Beim Anlegen einer Spannung an die Elektrodenschichten tritt eine Verformung des piezokeramischen Materials auf. Diese Verformung kann auch als piezoelektrischer Hub bezeichnet werden.

In einer Ausführungsform der Aktoreinheit weist der Piezoaktor zwei Anschlusselemente auf. Die Anschlusselemente ragen aus der ersten Stirnfläche des Piezoaktors heraus.

Die Anschlusselemente dienen zur externen Kontaktierung der Aktoreinheit. Vorzugsweise ist an zwei Seitenflächen des Stapels je ein Anschlusselement angebracht. Die Anschlusselemente können als Pins ausgeführt sein.

In einer Ausführungsform der Aktoreinheit ist der Teilbereich der Anschlusselemente, welcher aus der ersten Stirnfläche des Piezoaktors herausragt, frei von Vergussmasse.

Da die Vergussmasse bis an die erste Stirnfläche des Piezoaktors reicht, können die aus der Seite der ersten Stirnfläche des Piezoaktors herausragenden Anschusselemente frei von Vergussmasse gehalten werden. Aufwändiges Reinigen der Anschlusselemente wird somit überflüssig. Eine automatische Fertigung der Aktoreinheit wird dadurch begünstigt. Weiterhin kann die Lebensdauer der Aktoreinheit somit erhöht werden, da die Anschlusselemente frei von Verunreinigungen durch die Vergussmasse gehalten werden. Weiterhin wird ein Verfahren zur Fertigung der oben beschriebenen Aktoreinheit angegeben. Dabei wird in einem ersten Schritt der Piezoaktor in die Hülse eingebracht. In einem zweiten Schritt wird die Vergussmasse in die Hülse eingebracht. Die Vergussmasse dient zum Auffüllen eines Hohlraums zwischen der Innenseite der Hülse und dem Piezoaktor. In einem dritten Schritt wird der Hohlraum mit der Vergussmasse befüllt. Der Hohlraum wird vorzugsweise derart befüllt, dass die Vergussmasse bis an die erste Stirnfläche des Piezoaktors reicht. Erfindungsgemäß schließt die Vergussmasse bündig mit der ersten Stirnfläche der Hülse und des Piezoaktors ab. Sobald die Vergussmasse bündig mit der ersten Stirnfläche der Hülse abschließt, wird das Befüllen gestoppt, so dass die Vergussmasse das Niveau der ersten Stirnfläche des Piezoaktors nicht überschreitet.

Die Vergussmasse kann beispielsweise von der Seite der ersten Stirnfläche der Hülse aus über die Öffnung in der ersten Stirnfläche in die Hülse eingebracht werden. In einer weiteren Ausführungsform kann die Vergussmasse von der Seite der zweiten Stirnfläche der Hülse aus eingebracht werden. Dafür kann die zweite Stirnfläche eine Öffnung, beispielsweise eine Bohrung, aufweisen, über die ein Befüllelement in die Hülse eingebracht werden kann.

Der Hohlraum wird vorzugsweise derart befüllt, dass Turbulenzen in der Vergussmasse, die beispielsweise zu Lufteinschlüssen in der Vergussmasse führen, vermieden werden. Dies kann beispielsweise durch sehr langsames Befüllen oder aber durch eine spezielle Führung des Befüllelements erreicht werden. Beispielsweise kann das Befüllelement beim Befüllen immer knapp über dem Vergussmassenniveau gehalten werden.

In einer Ausführungsform weist das Verfahren weiterhin den Schritt des Anbringens eines Dichtelements an der zweiten Stirnfläche der Hülse vor dem Befüllen des Hohlraums auf. Das Dichtelement ist vorzugsweise lösbar an der zweiten Stirnfläche der Hülse angebracht. Das Dichtelement dient zum Abdichten der zweiten Stirnfläche der Hülse. Das Dichtelement ist derart an der zweiten Stirnfläche der Hülse angebracht, dass ein Austreten der Vergussmasse aus der Seite der zweiten Stirnfläche der Hülse beim Befüllen des Hohlraums verhindert wird.

Auf Grund von Fertigungstoleranzen kann es zu einem Spalt zwischen dem Durchbruch an der zweiten Stirnseite der Hülse und dem Piezoaktor kommen. Durch diesen Spalt kann Vergussmasse beim Vergießen der Aktoreinheit austreten. Das Dichtelement dichtet die zweite Stirnfläche der Hülse gegen ein Austreten der Vergussmasse ab.

In einer Ausführungsform weist das Verfahren weiterhin den Schritt des Aushärtens der Vergussmasse auf. In einem letzten Schritt wird das Dichtelement von der zweiten Stirnfläche der Hülse nach dem Aushärtevorgang entfernt.

Nach dem Aushärten der Vergussmasse ist ein Austreten der Vergussmasse aus der Seite der zweiten Stirnfläche der Hülse nicht mehr möglich. Damit wird das Dichtelement an der zweiten Stirnfläche der Hülse überflüssig und kann entfernt werden. Da das Dichtelement lösbar an der zweiten Stirnfläche der Hülse angebracht, zum Beispiel angepresst, ist kann dies in einem automatisierten Schritt ohne großen zusätzlichen Aufwand erfolgen.

Die beschriebenen Gegenstände werden anhand der folgenden Ausführungsbeispiele und Figuren näher erläutert. Dabei zeigt:
- Figur 1: eine schematische Darstellung eines Piezoaktors,
- Figur 2: eine schematische Darstellung einer Aktoreinheit,
- Figur 3: eine schematische Darstellung der Aktoreinheit aus Figur 2 während des Vergießens,
- Figur 4: eine schematische Darstellung der Aktoreinheit aus Figur 2 während des Vergießens in einer weiteren Ausführungsform.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit bzw. zum besseren Verständnis übertrieben dick oder groß dimensioniert dargestellt sein.

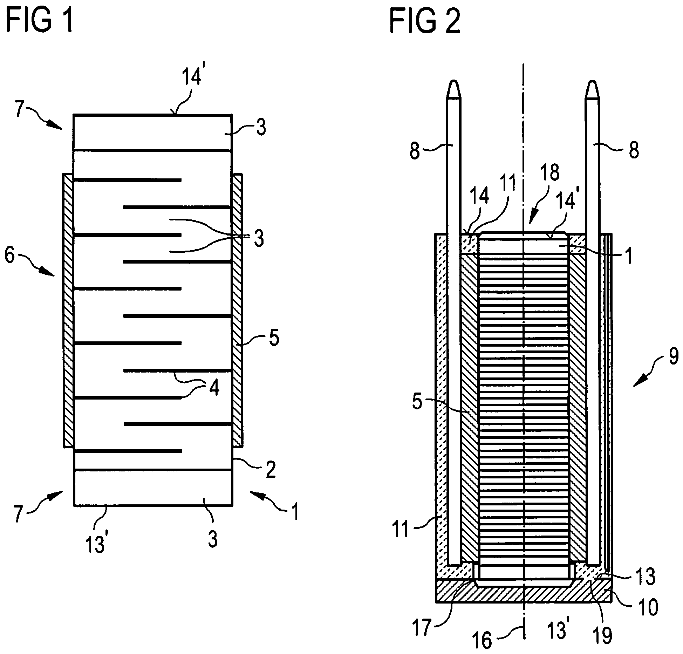

Figur 1 zeigt einen vielschichtigen Piezoaktor 1. Der Piezoaktor 1 weist einen Stapel 2 aus mehreren übereinander angeordneten piezoelektrischen Schichten 3 auf. Der Piezoaktor 1 weist eine erste Stirnfläche 14' und eine zweite Stirnfläche 13' auf.

Entlang der Stapelrichtung ist der Stapel 2 in einen aktiven Bereich 6 und zwei inaktive Bereiche 7 unterteilt. Die inaktiven Bereiche 7 grenzen in Stapelrichtung an den aktiven Bereich 6 an und bilden die Endstücke des Stapels 2. Der aktive Bereich 6 des Stapels 2 weist zwischen den piezoelektrischen Schichten 3 angeordnete Elektrodenschichten 4 auf. Um die Elektrodenschichten 4 im aktiven Bereich 6 einfach kontaktieren zu können, ist der Piezoaktor 1 so ausgebildet, dass sich nur jeweils der gleichen elektrischen Polarität zugeordnete Elektrodenschichten 4 bis zu einem Randbereich des Piezoaktors 1 erstrecken. Die der anderen elektrischen Polarität zugeordneten Elektrodenschichten 4 erstrecken sich an dieser Stelle nicht bis ganz zum Rand des Piezoaktors 1. Die Elektrodenschichten 4 sind demnach jeweils in Form von ineinander geschobenen Kämmen ausgebildet. Über Kontaktflächen in Form von Metallisierungen 5 an der Außenseite des Stapels 2 kann an die Elektrodenschichten 4 eine elektrische Spannung angelegt werden. Beim Anlegen einer Spannung an die Elektrodenschichten 4 tritt eine Verformung des piezoelektrischen Materials im aktiven Bereich 6 auf.

Die Metallisierungen 5 sind jeweils mit einem als Draht oder Pin ausführten Anschlusselement 8 (siehe Figuren 2 bis 4) verbunden, welches eine elektrische Kontaktierung des Piezoaktors 1 nach außen ermöglicht.

Figur 2 zeigt eine schematische Darstellung einer Aktoreinheit.

Die Aktoreinheit weist eine Hülse 9 auf. Die Hülse 9 ist zylinderförmig ausgebildet. Die Hülse 9 besteht beispielsweise aus Polybutylenterephthalat (PBT). Die Hülse 9 ist einstückig ausgeführt. Die Hülse 9 weist eine erste Stirnfläche 14 und eine zweite Stirnfläche 13 auf. Der Piezoaktor 1 aus Figur 1 ist in der Hülse 9 angeordnet. Der Piezoaktor 1 ist insbesondere derart in der Hülse 9 angeordnet, dass die erste Stirnfläche 14' des Piezoaktors 1 näher an der ersten Stirnfläche 14 der Hülse 9 angeordnet ist als die zweite Stirnfläche 13' des Piezoaktors 1.

Die erste Stirnfläche 14 der Hülse 9 weist eine Öffnung 18 auf. Die Öffnung 18 ist zur Aufnahme des Piezoaktors 1 in den Innenraum der Hülse 9 ausgelegt. Die Höhe bzw. Länge der Hülse 9 entspricht in etwa der Höhe des Piezoaktors 1. In diesem Ausführungsbeispiel schließt die erste Stirnfläche 14' des Piezoaktors 1 bündig mit der ersten Stirnfläche 14 der Hülse ab. Die erste Stirnfläche 14' des Piezoaktors 1 und die erste Stirnfläche 14 der Hülse weisen folglich die gleiche axiale Position in Bezug auf die Hauptachse 16 der Aktoreinheit oder der Hülse 9 auf, wobei sich die Hauptachse 16 zwischen der ersten Stirnfläche 14 und der zweiten Stirnfläche 13 der Hülse 9 erstreckt. Die Anschlusselemente 8 des Piezoaktors 1 ragen aus der ersten Stirnfläche 14' des Piezoaktors 1 und, folglich, auch aus der ersten Stirnfläche 14 der Hülse 9 heraus.

Die zweite Stirnfläche 13 der Hülse 9 bildet den Boden der Hülse 9. Die zweite Stirnfläche 13 weist einen Durchbruch 17 auf. Der Durchbruch ist ein Vierkantdurchbruch. Die Hauptachse 16 verläuft durch die Öffnung 17. Die zweite Stirnfläche 13' des Piezoaktors 1 ist in die Öffnung 17 eingeführt bzw. durch diese hindurchgeführt. Die zweite Stirnfläche 13' des Piezoaktors 1 ragt aus der Öffnung 17 und somit über die zweite Stirnfläche 13 der Hülse 9 hinaus.

Zwischen der Öffnung 17 und dem Piezoaktor 1 kann es auf Grund von Fertigungstoleranzen zu einer Lücke bzw. einem Spalt (nicht explizit dargestellt) kommen. Durch diese Lücke kann Vergussmaterial 1 beim Vergießen der Aktoreinheit austreten. Um ein Austreten der Vergussmasse 11 aus der Öffnung 17 und, folglich, aus der Seite der zweiten Stirnfläche 13 der Hülse 9 zu verhindern, ist ein Dichtelement 10 an der zweiten Stirnfläche 13 der Hülse 9 angebracht. Das Dichtelement 10 verschließt die zweite Stirnfläche 13 der Hülse 9.

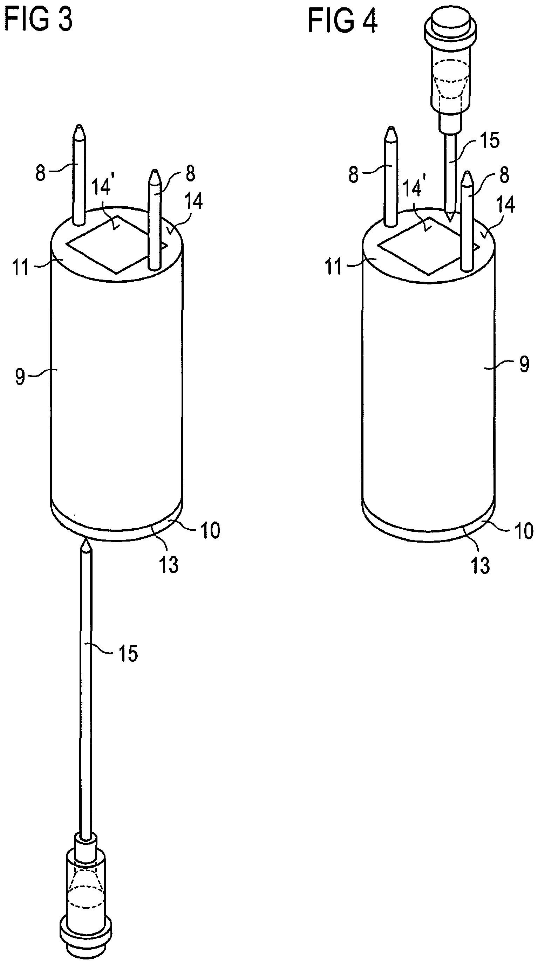

Das Dichtelement 10 ist auf die Stirnfläche 13 der Hülse maschinell aufgepresst. Das Dichtelement 10 ist lösbar angebracht. Das Dichtelement 10 ist lediglich während des Vergießens der Aktoreinheit sowie während eines anschließenden Aushärtevorgangs der Vergussmasse 11 angebracht, wie in Zusammenhang mit den Figuren 3 und 4 näher erläutert wird.

Das Dichtelement 10 ist eine Dichtscheibe. Das Dichtelement 10 ist verformbar. Das Dichtelement 10 besteht aus einem Schaumstoff. Beim Anbringen des Dichtelements 10 an die zweite Stirnfläche 13 der Hülse 9 passt sich das Dichtelement 10 an die aus der Seite der zweiten Stirnfläche 13 der Hülse 9 herausragende zweiten Stirnfläche 13' des Piezoaktors 1 an. Die Vergussmasse 11 umhüllt den Piezoaktor 1. Die Vergussmasse 11 enthält ein Silikon-Elastomer. Neben Silikon-Elastomer kann die Vergussmasse 11 einen Quarzsand sowie haftvermittelnde Materialien aufweisen. Die Vergussmasse 11 steht mit der Außenseite des Piezoaktors 1 in Verbindung, d.h. sowohl mit Außenflächen der piezokeramischen Schichten 3 als auch mit den Außenflächen der Metallisierungen 5 sowie den Anschlusselementen 8. Nach außen wird die Vergussmasse 11 von der Hülse 9 begrenzt. Erfindungsgemäß ist die Vergussmasse 11 auf Niveau aufgefüllt. Die Vergussmasse 11 schließt bündig mit der ersten Seitenfläche 14' des Piezoaktors 1 und, folglich, mit der ersten Seitenfläche 14 der Hülse 9 ab. In jedem Fall überschreitet die Vergussmasse 11 das Niveau der ersten Stirnfläche 14' des Piezoaktors 1 nicht. Insbesondere ist der Bereich der Anschlusselemente 8, welcher aus der ersten Stirnfläche 14' des Piezoaktors 1 herausragt, frei von Vergussmasse 11. Aufwändige Reinigungsarbeiten der Anschlusselemente 8 nach dem Vergießen der Aktoreinheit entfallen dadurch. Ein automatischer Herstellungsprozess der Aktoreinheit wird somit erleichtert.

Die Figuren 3 und 4 zeigen die beschrieben Aktoreinheit aus während deren Fertigung, insbesondere während des Vergießens.

In einem ersten Fertigungsschritt der Aktoreinheit wird der Piezoaktor 1 über die Öffnung 18 in die Hülse 9 eingebracht, so dass die zweite Stirnfläche 13' des Piezoaktors 1 über den Durchbruch 17 aus der zweiten Stirnfläche 13 der Hülse 9 hinausragt. Die erste Stirnfläche 14' des Piezoaktors 1 ist bündig mit der ersten Stirnfläche 14 der Hülse 9, wie in Zusammenhang mit Figur 2 beschrieben wurde.

In einem nächsten Schritt wird das oben beschriebene Dichtelement 10 derart an der zweiten Stirnfläche 13 der Hülse 9 angebracht, dass die zweite Stirnfläche 13 gegen ein Austreten der Vergussmasse 11 beim Vergießen abgedichtet ist.

In einen weiteren Schritt wird die Vergussmasse 11 in die Hülse 9 eingebracht, um den Hohlraum zwischen der Innenseite der Hülse 9 und dem Piezoaktor 1 aufzufüllen. Das Einbringen der Vergussmasse 11 geschieht über ein Befüllelement 15. Das Befüllelement 15 ist eine Nadel.

In einem weiteren Schritt wird der Hohlraum mit der Vergussmasse derart befüllt, dass die Vergussmasse bündig mit der ersten Stirnfläche 14 des Piezoaktors 14 abschließt. Das Befüllen kann dabei von der Seite der ersten Stirnfläche 14 der Hülse 9 erfolgen (siehe Figur 4). Dabei wird das Befüllelement 15 von der Seite der ersten Stirnfläche 14 der Hülse 9 aus in den Hohlraum bis nahe an die zweite Stirnfläche 13 geführt. Beim Befüllen des Hohlraums wird das Befüllelement 15 in Richtung der ersten Stirnfläche 14 bewegt (nicht explizit dargestellt), wobei das Befüllelement 15, insbesondere eine Befüllöffnung des Befüllelements 15, immer knapp über dem Vergussmassenniveau gehalten wird, um ein gleichmäßiges Befüllen zu ermöglichen und Turbulenzen, die zu Lufteinschlüssen in der Vergussmasse 11 führen können, zu vermeiden.

Das Befüllen kann auch von der Seite der zweiten Stirnfläche 13 der Hülse 9 erfolgen (siehe Figur 3). Dabei wird das Befüllelement 15 von der Seite der zweiten Stirnfläche 14 der Hülse 9 aus in den Hohlraum eingeführt. Für diese Art des Befüllens weist die Hülse 9, insbesondere die zweite Stirnfläche 13 der Hülse 9, eine weitere Öffnung 19 (siehe Figur 2) auf, über die das Befüllelement 15 in den Hohlraum eingebracht wird. Die Öffnung 19 ist bezüglich der Hauptachse 16 radial zum Durchbruch 17 versetzt. Beim Einbringen des Befüllelements 15 in den Hohlraum über die Öffnung 19, wird das Dichtelement 10 durch das Befüllelement 15 durchstochen. Da das Dichtelement 10 aus einem flexiblen Material, beispielsweise Schaumstoff, besteht, verschließt sich die Durchstechöffnung wieder automatisch, wodurch es zu keinem Austreten der Vergussmasse 11 durch die Durchstechöffnung kommt.

Nach dem Befüllen des Hohlraums wird das Befüllelement 15 entfernt. In einem nächsten Schritt wird die Vergussmasse 11 ausgehärtet. Nach dem Aushärten der Vergussmasse 11 wird das Dichtelement 10 von der zweiten Stirnfläche 13 der Hülse 9 entfernt.

### Bezugszeichenliste

- 1: Piezoaktor
- 2: Stapel
- 3: Piezoelektrische Schicht
- 4: Elektrodenschicht
- 5: Metallisierung
- 6: Aktiver Bereich
- 7: Inaktiver Bereich
- 8: Anschlusselement
- 9: Hülse
- 10: Dichtelement
- 11: Vergussmasse
- 13: Stirnfläche
- 14: Stirnfläche
- 13': Stirnfläche
- 14': Stirnfläche
- 15: Befüllelement
- 16: Hauptachse
- 17: Durchbruch
- 18: Öffnung
- 19: Öffnung

## Patentansprüche

1. Aktoreinheit umfassend
- einen Piezoaktor (1) aufweisend eine erste Stirnfläche (14') und eine zweite Stirnfläche (13'),
- eine Hülse (9) zur Aufnahme des Piezoaktors (1), wobei die Hülse (9) eine erste Stirnfläche (14) und eine von der ersten Stirnfläche (14) verschieden ausgebildete zweite Stirnfläche (13) aufweist,
- eine den Piezoaktor (1) umgebende Vergussmasse (11), wobei der Piezoaktor (1) und die Vergussmasse (11) in die Hülse (9) eingebracht sind, und wobei die Vergussmasse (11) bündig bis an die erste Stirnfläche (14') des Piezoaktors (1) und an die erste Stirnfläche (14) der Hülse (9) reicht,
- zwei Anschlusselemente (8), die jeweils aus einem ersten Teilbereich und einem sich an den ersten Teilbereich unmittelbar anschließenden zweiten Teilbereich bestehen, wobei der komplette jeweilige zweite Teilbereich der Anschlusselemente (8) aus der ersten Stirnfläche (14') des Piezoaktors (1) herausragt und frei von Vergussmasse ist,
- wobei die erste Stirnfläche (14) der Hülse (9) eine Öffnung (18) aufweist, die zum Einbringen des Piezoaktors (1) in die Hülse (9) geeignet ist,
- wobei die zweite Stirnfläche (13) der Hülse (9) einen Durchbruch (17) aufweist, und wobei die zweite Stirnfläche (13') des Piezoaktors (1) in den Durchbruch (17) eingeführt ist,
- wobei der komplette jeweilige erste Teilbereich der beiden Anschlusselemente (8) von der Vergussmasse (11) umgeben ist.

2. Aktoreinheit nach Anspruch 1,
wobei die Vergussmasse (11) mit der ersten Stirnfläche (14') des Piezoaktors (1) bündig abschließt, und wobei die erste Stirnfläche (14') des Piezoaktors (1) näher an der ersten Stirnfläche (14) der Hülse (9) angeordnet ist als die zweite Stirnfläche (13') des Piezoaktors (1).

3. Aktoreinheit nach Anspruch 1 oder Anspruch 2,
wobei die erste Stirnfläche (14') des Piezoaktors (1) und die erste Stirnfläche (14) der Hülse (9) die gleiche axiale Position in Bezug auf die Hauptachse (16) der Aktoreinheit aufweisen.

4. Aktoreinheit nach einem der vorigen Ansprüche,
wobei die Hülse (9) einstückig ausgebildet ist.

5. Aktoreinheit nach einem der vorigen Ansprüche,
wobei die zweite Stirnfläche (13') des Piezoaktors (1) derart in den Durchbruch (17) eingeführt ist, dass die zweite Stirnfläche (13') des Piezoaktors (1) aus der zweiten Stirnfläche (13) der Hülse (9) herausragt.

6. Aktoreinheit nach einem der vorigen Ansprüche,
wobei das Material der Hülse (9) PBT aufweist.

7. Aktoreinheit nach einem der vorigen Ansprüche,
wobei der Piezoaktor (1) einen Stapel (2) von piezokeramischen Schichten (3) sowie zwischen den piezokeramischen Schichten (3) angeordneten Elektrodenschichten (4) umfasst, und wobei die Elektrodenschichten (4) gegenpolig kontaktiert sind.

8. Verfahren zur Fertigung einer Aktoreinheit nach einem der vorigen Ansprüche umfassend die folgenden Schritte:
A) Bereitstellen eines Piezoaktors (1) und einer Hülse (9), wobei der Piezoaktor (1) mit zwei Anschlusselementen (8), die jeweils aus einem ersten Teilbereich und einem sich an den ersten Teilbereich unmittelbar anschließenden zweiten Teilbereich bestehen, verbunden ist, wobei die Hülse (9) eine erste Stirnfläche (14) und eine zweite von der ersten Stirnfläche verschieden ausgebildete Stirnfläche (13) aufweist, wobei die erste Stirnfläche (14) der Hülse (9) eine Öffnung (18) aufweist, die zum Einbringen des Piezoaktors (1) in die Hülse (9) geeignet ist, und die zweite Stirnfläche (13) der Hülse (9) einen Durchbruch (17) aufweist,
B) Einbringen des Piezoaktors (1) in die Hülse (9) derart, dass die zweite Stirnfläche (13') des Piezoaktors (1) in den Durchbruch (17) eingeführt ist,
C) Einbringen der Vergussmasse (11) in die Hülse (9) zum Auffüllen eines Hohlraums zwischen der Innenseite der Hülse (9) und dem Piezoaktor (1),
D)Befüllen des Hohlraums mit der Vergussmasse (11), so dass die Vergussmasse (11) bis an die erste Stirnfläche (14') des Piezoaktors (1) reicht und der jeweilige erste Teilbereich der beiden Anschlusselemente (8) komplett von der Vergussmasse (11) umgeben ist und der komplette jeweilige zweite Teilbereich der beiden Anschlusselemente (8) freiliegend über der Vergussmasse (11) angeordnet ist.

9. Verfahren nach Anspruch 8,
umfassend den Schritt:
E)Anbringen eines Dichtelements (10) an der zweiten Stirnfläche (13) der Hülse (9) zum Abdichten der zweiten Stirnfläche (13) der Hülse (9) vor dem Befüllen des Hohlraums, wobei das Dichtelement (10) derart an der zweiten Stirnfläche (13) der Hülse (9) angebracht ist, dass ein Austreten der Vergussmasse (11) aus der Seite der zweiten Stirnfläche (13) der Hülse (9) beim Befüllen des Hohlraums verhindert wird.

10. Verfahren nach Anspruch 9
aufweisend die Schritte:
F)Aushärten der Vergussmasse (11),
G)Entfernen des Dichtelements (10) von der zweiten Stirnfläche (13) der Hülse (9) nach dem Aushärtevorgang.

## Claims

1. Actuator unit comprising
- a piezoactuator (1) having a first end face (14') and a second end face (13'),
- a sleeve (9) for receiving the piezoactuator (1), the sleeve (9) having a first end face (14) and a second end face (13), formed differently from the first end face (14),
- a casting compound (11), which surrounds the piezoactuator (1),
the piezoactuator (1) and the casting compound (11) having been introduced into the sleeve (9), and the casting compound (11) reaching up to flush with the first end face (14') of the piezoactuator (1) and the first end face (14) of the sleeve (9),
- two connection elements (8), which consist in each case of a first partial region and a second partial region, directly adjoining the first partial region, the complete respective second partial region of the connection elements (8) protruding out of the first end face (14') of the piezoactuator (1) and being free of casting compound,
- the first end face (14) of the sleeve (9) having an opening (18), which is suitable for introducing the piezoactuator (1) into the sleeve (9),
- the second end face (13) of the sleeve (9) having an aperture (17), and the second end face (13') of the piezoactuator (1) being inserted in the aperture (17),
- the complete respective first partial region of the two connection elements (8) being surrounded by the casting compound (11).

2. Actuator unit according to Claim 1,
the casting compound (11) terminating flush with the first end face (14') of the piezoactuator (1), and the first end face (14') of the piezoactuator (1) being arranged closer to the first end face (14) of the sleeve (9) than the second end face (13') of the piezoactuator (1).

3. Actuator unit according to Claim 1 or 2,
the first end face (14') of the piezoactuator (1) and the first end face (14) of the sleeve (9) having the same axial position with respect to the main axis (16) of the actuator unit.

4. Actuator unit according to one of the preceding claims,
the sleeve (9) being formed in one piece.

5. Actuator unit according to one of the preceding claims,
the second end face (13') of the piezoactuator (1) being inserted in the aperture (17) in such a way that the second end face (13') of the piezoactuator (1) protrudes from the second end face (13) of the sleeve (9).

6. Actuator unit according to one of the preceding claims,
the material of the sleeve (9) comprising PBT.

7. Actuator unit according to one of the preceding claims,
the piezoactuator (1) comprising a stack (2) of piezoceramic layers (3) and electrode layers (4) arranged between the piezoceramic layers (3), and the electrode layers (4) being contacted with opposing polarities.

8. Method for producing an actuator unit according to one of the preceding claims, comprising the following steps:
A) providing a piezoactuator (1) and a sleeve (9), the piezoactuator (1) being connected by two connection elements (8), which consist in each case of a first partial region and a second partial region, directly adjoining the first partial region, the sleeve (9) having a first end face (14) and a second end face (13), formed differently from the first end face, the first end face (14) of the sleeve (9) having an opening (18), which is suitable for introducing the piezoactuator (1) into the sleeve (9), and the second end face (13) of the sleeve (9) having an aperture (17),
B) introducing the piezoactuator (1) into the sleeve (9) in such a way that the second end face (13') of the piezoactuator (1) is inserted in the aperture (17),
C) introducing the casting compound (11) into the sleeve (9) for filling a cavity between the inner side of the sleeve (9) and the piezoactuator (1),
D) filling the cavity with the casting compound (11), so that the casting compound (11) reaches up to the first end face (14') of the piezoactuator (1) and the respective first partial region of the two connection elements (8) is completely surrounded by the casting compound (11) and the complete respective second partial region of the two connection elements (8) is arranged lying freely over the casting compound (11).

9. Method according to Claim 8,
comprising the step of:
E) attaching a sealing element (10) to the second end face (13) of the sleeve (9) for sealing off the second end face (13) of the sleeve (9) before the filling of the cavity, the sealing element (10) being attached to the second end face (13) of the sleeve (9) in such a way that the casting compound (11) is prevented from escaping from the side of the second end face (13) of the sleeve (9) during the filling of the cavity.

10. Method according to Claim 9,
comprising the steps of:
F) curing the casting compound (11),
G) removing the sealing element (10) from the second end face (13) of the sleeve (9) after the curing process.

## Revendications

1. Unité à actionneur, comprenant
- un actionneur piézoélectrique (1) qui possède une première surface frontale (14') et une deuxième surface frontale (13'),
- un manchon (9) destiné à accueillir l'actionneur piézoélectrique (1), le manchon (9) possédant une première surface frontale (14) et une deuxième surface frontale (13) ayant une configuration différente de celle de la première surface frontale (14),
- une masse de scellement (11) qui entoure l'actionneur piézoélectrique (1), l'actionneur piézoélectrique (1) et la masse de scellement (11) étant incorporés dans le manchon (9) et la masse de scellement (11) s'étendant à fleur jusqu'à la première surface frontale (14') de l'actionneur piézoélectrique (1) et jusqu'à la première surface frontale (14) du manchon (9),
- deux éléments de raccordement (8), lesquels se composent respectivement d'une première zone partielle et d'une deuxième zone partielle qui se rattache directement à la première zone partielle, l'intégralité de la deuxième zone partielle respective des éléments de raccordement (8) faisant saillie hors de la première surface frontale (14') de l'actionneur piézoélectrique (1) et étant exempte de masse de scellement,
- la première surface frontale (14) du manchon (9) possédant une ouverture (18) qui est conçue pour introduire l'actionneur piézoélectrique (1) dans le manchon (9),
- la deuxième surface frontale (13) du manchon (9) possédant une traversée (17) et la deuxième surface frontale (13') de l'actionneur piézoélectrique (1) étant insérée dans la traversée (17),
- l'intégralité de la première zone partielle respective des deux éléments de raccordement (8) étant entourée par la masse de scellement (11).

2. Unité à actionneur selon la revendication 1, la masse de scellement (11) se terminant à fleur de la première surface frontale (14') de l'actionneur piézoélectrique (1), et la première surface frontale (14') de l'actionneur piézoélectrique (1) étant disposée plus proche de la première surface frontale (14) du manchon (9) que la deuxième surface frontale (13') de l'actionneur piézoélectrique (1).

3. Unité à actionneur selon la revendication 1 ou la revendication 2, la première surface frontale (14') de l'actionneur piézoélectrique (1) et la première surface frontale (14) du manchon (9) présentant la même position axiale par rapport à l'axe principal (16) de l'unité à actionneur.

4. Unité à actionneur selon l'une des revendications précédentes, le manchon (9) étant réalisé monobloc.

5. Unité à actionneur selon l'une des revendications précédentes, la deuxième surface frontale (13') de l'actionneur piézoélectrique (1) étant insérée dans la traversée (17) de telle sorte que la deuxième surface frontale (13') de l'actionneur piézoélectrique (1) fait saillie hors de la deuxième surface frontale (13) du manchon (9).

6. Unité à actionneur selon l'une des revendications précédentes, le matériau du manchon (9) présentant du PBT.

7. Unité à actionneur selon l'une des revendications précédentes, l'actionneur piézoélectrique (1) comprenant une pile (2) de couches en piézocéramique (3) ainsi que des couches d'électrode (4) disposées entre les couches en piézocéramique (3), et les couches d'électrode (4) étant mises en contact avec des polarités opposées.

8. Procédé de fabrication d'une unité à actionneur selon l'une des revendications précédentes, comprenant les étapes suivantes :
A) fourniture d'un actionneur piézoélectrique (1) et d'un manchon (9), l'actionneur piézoélectrique (1) étant relié à deux éléments de raccordement (8), lesquels se composent respectivement d'une première zone partielle et d'une deuxième zone partielle qui se rattache directement à la première zone partielle, le manchon (9) possédant une première surface frontale (14) et une deuxième surface frontale (13) ayant une configuration différente de celle de la première surface frontale, la première surface frontale (14) du manchon (9) possédant une ouverture (18) qui est conçue pour introduire l'actionneur piézoélectrique (1) dans le manchon (9) et la deuxième surface frontale (13) du manchon (9) possédant une traversée (17),
B) introduction de l'actionneur piézoélectrique (1) dans le manchon (9) de telle sorte que la deuxième surface frontale (13') de l'actionneur piézoélectrique (1) est insérée dans la traversée (17),
C) introduction de la masse de scellement (11) dans le manchon (9) en vue de remplir un espace creux entre le côté intérieur du manchon (9) et l'actionneur piézoélectrique (1),
D) remplissage de l'espace creux avec la masse de scellement (11), de sorte que la masse de scellement (11) parvienne jusqu'à la première surface frontale (14') de l'actionneur piézoélectrique (1) et la première zone partielle respective des deux éléments de raccordement (8) soit entièrement entourée par la masse de scellement (11) et l'intégralité de la deuxième zone partielle respective des deux éléments de raccordement (8) soit disposée dégagée au-dessus de la masse de scellement (11).

9. Procédé selon la revendication 8, comprenant l'étape suivante :
E) application d'un élément d'étanchéité (10) sur la deuxième surface frontale (13) du manchon (9) en vue de rendre étanche la deuxième surface frontale (13) du manchon (9) avant le remplissage de l'espace creux, l'élément d'étanchéité (10) étant appliqué sur la deuxième surface frontale (13) du manchon (9) de telle sorte qu'un débordement de la masse de scellement (11) par le côté de la deuxième surface frontale (13) du manchon (9) est empêché lors du remplissage de l'espace creux.

10. Procédé selon la revendication 9, comprenant les étapes suivantes :
F) durcissement de la masse de scellement (11),
G) enlèvement de l'élément d'étanchéité (10) de la deuxième surface frontale (13) du manchon (9) après l'opération de durcissement.
